# EUROPEAN PATENT APPLICATION

(11) **EP 1 357 390 A1**
(43) Date of publication of application: **29.10.2003**
(21) Application number: 01994843.9
(22) Date of filing: 27.12.2001
(51) Int. Cl.: G01R 31/36

(54) **SYSTEM FOR DYNAMIC EVALUATION OF THE STATE OF HEALTH AND CHARGE OF A VEHICLE BATTERY**

(30) Priority: 29.12.2000 ES 200003143
(71) Applicant: Lear Automotive (EEDS) Spain, S.L., 43800 Valls, Tarragona (ES)
(72) Inventor: GIRO ROCA, Jordi, E-43800 Valls (TA Valls) (ES); BIGORRA VIVES, Jordi, E-43800 Valls (Tarragona) (ES); PUIG VIDAL, Manuel, E-43800 Valls (Tarragona) (ES); RUIZ SANCHEZ, Oscar, E-43800 Valls (Tarragona) (ES); SAMITIER MARTI, Josep, E-43800 Valls (Tarragona) (ES)
(74) Representative: Primo de Rivera y Urquijo, Jose Antonio
(86) International application number: ES0100507
(87) International publication number: WO02054096

(57) **Abstract**

A system for the dynamic evaluation of the state of health and charge of the battery of a vehicle.

The system, assembled in the vehicle, measures the electrochemical impedance of a battery by means of:
- means (5) for generating a sinusoidal alternating current applied to the battery posts;
- means for measuring the voltage drop caused by the passage of said current;
- means (2) for filtering and conditioning said voltage drop, and
- means (3, 10) for obtaining the actual and imaginary components of said electrochemical impedance;
comprising a unipolar architecture where the injected signal is an alternating component at only one frequency, coming from an oscillator, continuously superimposed on a reference component, the measurements of the actual and imaginary components being carried out continuously in time together with the acquisition of a voltage proportional to the injected current at all times.

## Description

### Field of the Invention

The present invention refers to a system proposed for a dynamic evaluation of the state of health (SOH), that is to say the current capacity (at any given time) of absorbing and/or delivering energy with respect to the rating of a battery or actual capacity after recharging, as well as the state of charge (SOC) of a vehicle battery, or the amount of stored energy with respect to the available capacity, and therefore the actual capacity that it can provide during an immediate discharge.

The reference to a battery or battery element/unit will be understood throughout this specification as a secondary (reversible electrochemical action) or accumulator battery, and particularly a battery for an automobile, the system, implemented/assembled on the vehicle, being applied to said battery and the evaluation being carried out during the vehicle's functioning as well as in standstill.

The electrical system of a motor vehicle or automobile is a vital part of its functioning. The battery, as an energy storage element, is a key factor in the development of electrical systems with intelligent handling capacity (microcontrollers and management algorithms). These systems are becoming more necessary due to the increase in the demand of electric power in automobiles. Modern automobile batteries are specifically designed so as to provide elevated levels of current for engines coupled in starting with a comparatively small reserve capacity in order to handle the inactive charges and emergency functions when the charging circuit fails. A suitable voltage regulation is not only necessary for the protection of the system charges but also for a correct functioning and long life of the battery.

The system of this invention makes use of one impedance measurement technique called electrochemical impedance spectroscopy (or impedance in alternating current) based on the measurement of the increase of the sinusoidal voltage ΔV=Vₘₐₓ sen (2πft) when a sinusoidal current ΔI=Iₘₐₓ sen (2πft+Φ) is added to the normal charging and discharging current of the battery, f being the frequency and Iₘₐₓ the amplitude of the superimposed sinusoidal current, with whose magnitudes the electrochemical impedance of the battery is calculated Z(f)= Vₘₐₓ/Iₘₐₓ.

Consequently, the electrochemical impedance of a battery is a complex number which depends on the frequency, characterized by its actual and imaginary parts or by its module |Z| = Vₘₐₓ/Iₘₐₓ and its phase angle Φ. The system proposed herein proceeds to an acquisition of both components at all times, due to which the value of the injected current is also acquired at all times, measured through the corresponding voltage generated as a consequence of said current injection, in addition to the actual voltage existing in the battery posts and the temperature inside the battery, whose series of values is continuously and simultaneously fed to a microcontroller where several algorithms are applied in order to provide an evaluation of the SOH and SOC at all times.

The invention refers to a dynamic system, that is to say not conceived to be implemented in a laboratory or shop but rather precisely foreseen for its application in the vehicle, be it in a standstill state, before starting the engine, or during its functioning, providing the processing of all the mentioned measurements with a preventive and generally useful indication for an intelligent handling of the electrical system of the vehicle.

The system according to the present invention permits being included in an interconnections box with intelligent handling. Apart from this, said system has been implemented with design optimization by means of several electronic circuits such that its cost is very affordable and its function ensured in the vehicle area.

### Background of the Invention

The main problem for the methodology that this invention aims at is the exactness in the on-line determination of the SOC and the evolution of the SOH. The voltage measurement of the battery is not a suitable parameter for establishing a good correlation with the battery's SOH. It is known that the only reliable process for detecting premature capacity failures in batteries is the discharge test at a constant current at a specific voltage. However, this method is expensive, requires a lot of time and cannot be implemented for a dynamic scheduling.

The SOC and SOH evaluation of batteries subjected to different discharge cycles has been widely used in the last two decades for researching the kinetics of battery elements/units. In these prior studies, such as "A review of impedance measurements for determination of the state-of-charge or state-of-health of secondary batteries" F. Huet. Journal of Power Sources 70, pp. 59-69, (1998), many authors have concluded that the impedance techniques are a good method for providing a test of the SOC.

The representations of the module and of the phase of said electrochemical impedance with relation to the frequency by means of the Bode diagrams are usual in the characterization of electronic circuits although the most common representation in the field of batteries is the Nyquist diagram, which relates the imaginary part with the actual part of said impedance.

The main common features of the Nyquist diagrams applied to automobile batteries, particularly of lead-acid, are:
- an inductive part to frequencies greater than 100 Hz;
- a high frequency resistance R_{HF} in the range of mΩ which is the actual part of the impedance to frequencies greater than 100 Hz;
- a first and small capacitive loop for frequencies between 0.1 to 100 Hz;
- a second and broad capacitive loop for frequencies greater than 0.1 Hz.

Therefore, the SOC and SOH of batteries subjected to different charging-discharging cycles have been characterized in the laboratory by impedance measurements. Some of the parameters extracted from the R_{HF} spectrum, for example, are directly related to the battery's SOC. In addition, the R_{HF} ohmic resistance of the impedance measurement to elevated frequencies measurement is a substantial parameter which could be included in an on-line dynamic determination of the safety regions of the battery, carried out on the vehicle.

A very common method of studying the frequency dependent properties consists of modeling the unknown system by means of an electric circuit equivalent. Regarding this, one can cite the publication "Dynamic modeling of lead/acid batteries using impedance spectroscopy for parameter identification". P. Mauracher, E. Karden. Journal of Power Sources 67 pp. 69-94 (1997).

Methods and devices or systems for a controlled battery management appear in patents WO-A-98/53335, relating to a battery SOH control system, EP-A-884600, referring to a device and method for controlling the SOC of a battery, and in patent WO-A-98/58270, referring to a method and apparatus for evaluating and classifying batteries based on the application of microcharges or charge microimpulses to the battery, carrying out the classification in function of the profiles of the resulting voltages, or portions thereof taken in the battery posts.

Patent US-A-5,773,978 refers to an impedance control for a storage battery which includes a charging circuit coupled to the battery terminals in order to charge it such that a time dependent voltage component is generated in its posts, which has a peak-to-peak amplitude, the measurement unit connected to the battery posts including a peak detector in order to generate an indicative voltage based on the output of the impedance unit.

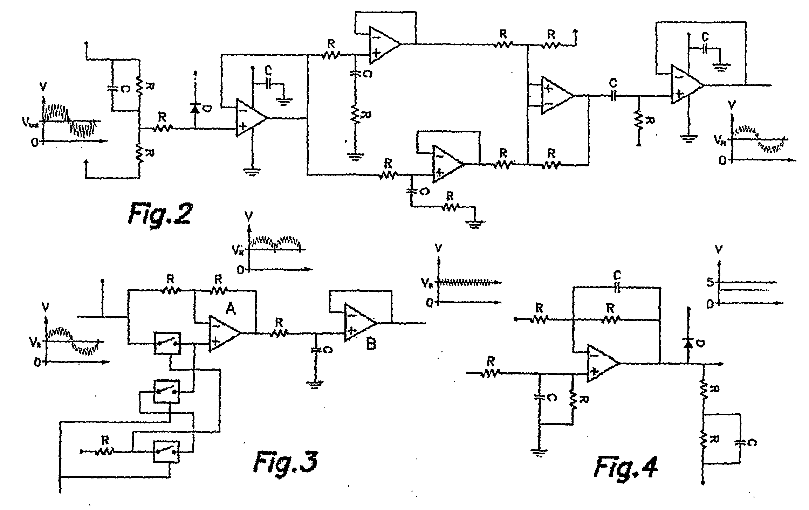

Patent WO-A-94/15222, related to a method and an apparatus for determining the state of charge of an electrochemical cell, is based on the evaluation of the rate of change of the electrochemical impedance of the cell upon varying the frequency, comparing the cell impedance to two or more frequencies. In one of its embodiment examples (figure 3 and corresponding description), this patent discloses a method and an apparatus for determining the state of charge of an electrochemical cell performing a synchronous detection of an alternating voltage signal, proportional to the impedance of the battery generated in the posts thereof, as a consequence of the injection of the current, alternately determining the resistive and reactive components of the impedance, such that the total impedance can be calculated by vector addition of the output voltages under two measurement conditions and division by the current applied to the battery, which can be measured by suitable means such as an AC current meter.

The method and apparatus of said patent has a first drawback in that it does not take into consideration the temperature of the battery (range of working temperatures comprised in a range of -40° to +125° C). Said method permits alternately acquiring the values of the normal and imaginary components of the proportional voltage generated by the injection of said alternating current, but it has not foreseen a continuous measurement of the injected signal and of its possible variations during the course of the measurements, especially concerning the elevated interferences due to temperature and tolerance of the components, such that the impedance values determined throughout a period of time can be erroneous.

The disclosed apparatus is based on a bipolar architecture (± Vcc), which would have a set of drawbacks if it were dynamically applied in the automobile, that is to say during its functioning, which are detailed below:
- given that there is only a unipolar system (0-Vcc) in the automobile, said bipolar architecture, according to the proposal of said patent, would oblige introducing a negative voltage generation system with the subsequent complexity for achieving said symmetrical source and requiring the use of a greater number of components;
- the generation of this negative voltage would be determinant in introducing a set of interferences which could be highly aggressive for a microcontroller if its use were foreseen for carrying out the evaluation in a dynamic manner.

Lastly, said patent does not foresee the evaluation of the state of health, not being able to therefore ensure that said battery still functions, that is to say it is not a system with a memory capable of storing anomalous situations.

Nor does this patent foresee a phase adjustment in relation to the working frequency in the voltage fed to the control block of the synchronous detection filter used.

Patent US-A-5,862,515 discloses a meter system for batteries which also comprises a bipolar architecture, no detection of the normal and imaginary components of the electrochemical impedance being carried out, and without it carrying out a synchronous detection either, that is to say at a determined frequency of the injected current.

All these methods and/or systems, and particularly that described in the next to last cited WO patent, are not sufficiently suitable for a measurement and eventual subsequent dynamic scheduling assembled in the automobile, since different charges and sources are connected to the battery terminals, which will also introduce their components into the output signal as from which the impedance must be measured, which must also consider the variations in the injected current, all this making the precision of the measurement difficult or making it impossible, as according to the means and measurements explained in such background.

### Brief Description of the Invention

Unlike the mentioned background, the present invention proposes a unipolar system where said synchronous detection of the alternating voltage signal, proportional to the battery impedance generated in the posts thereof, as a consequence of the current injection, is dynamically carried out such that all the components that could introduce other charges or sources connected to the battery are efficiently removed, also acquiring at all times the value of the injected current, the value of the actual voltage existing in the battery posts and the temperature of said battery, obtaining as from these values a highly reliable detection of the actual and imaginary components of the electrochemical impedance of the battery and a reliable evaluation of the SOC and SOH thereof.

More specifically, the proposed system, based on the electrochemical impedance measurement principles of a battery and comprising:
- means for generating an alternating sinusoidal current which is applied to the battery posts;
- means for measuring the voltage drop caused by the passage of said current;
- means for filtering and conditioning said voltage drop, using at least one synchronous filter controlled by the original generated current signal; and
- means for obtaining a continuous voltage value proportional to the electrochemical impedance of the battery, determining as from this voltage value the actual and imaginary components of the electrochemical impedance of the analyzed battery,
is characterized in that it is based on a unipolar architecture (mass and supply) such that the injected signal consists of an alternating component at only one frequency provided by an oscillator, continuously superimposed on a reference component, and in that it is foreseen for operating both in the standstill and running of the vehicle it is integrated in, obtaining the measurements of the actual and imaginary components in a continuous manner in time, using a synchronous detection filter controlled by the original generated current (injected to the battery posts) for such a purpose, for the acquisition of each one of said components and also for obtaining a voltage constantly proportional to the injected current, also by means of a synchronous detection filter.

As indicated, the system according to the invention is also characterized by additionally including:
- means for obtaining a voltage value in the battery posts at all times, and
- means for obtaining a voltage value which is proportional to the temperature inside the battery.

According to the invention, the determined values of the actual and imaginary components of the electrochemical impedance, together with the voltage values in the battery posts, the voltage value proportional to the temperature and the voltage value proportional to the injected current are fed to a microcontroller containing algorithms for calculating the state of charge and the state of health of the battery as from the set of said values introduced into said microcontroller.

In order to better understand the features of the system of this invention, it will now be described with reference to a possible embodiment example, provided for an illustrative and non-limiting purpose, shown on several sheets of drawings in which:

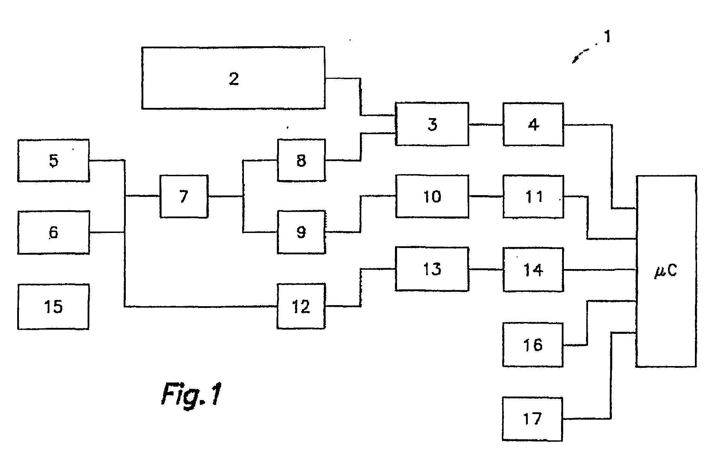

Figure 1 shows a block diagram showing a possible embodiment example of the system comprising different parts: acquisition stages of the actual and imaginary components of the voltage signal obtained as a consequence of the current signal injection, an acquisition stage of the voltage proportional to said injected current, an acquisition stage of the voltage in battery posts and an acquisition stage of the temperature inside the battery, necessary for implementing the system according to the invention. This figure shows that the five indicated values are continuously fed to a microcontroller.

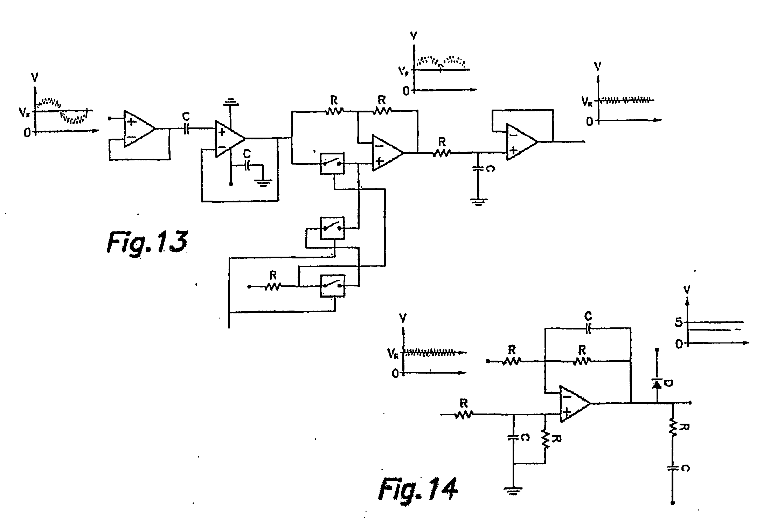

Figures 2 to 17 show a possible embodiment of each one of the blocks, the wave shapes of the input and output signal being detailed in the majority of said blocks in order to better understand the operating principal of the system. It should be pointed out that blocks 3, 10, and 13, relative to a synchronous filtering stage controlled by the original generated current signal, are significantly similar, and blocks 4, 11 and 14, applied to remove the reference signal, to filter and amplify the signal and to adapt it to a range of 0-5 V for its introduction into the microcontroller, are also significantly similar.

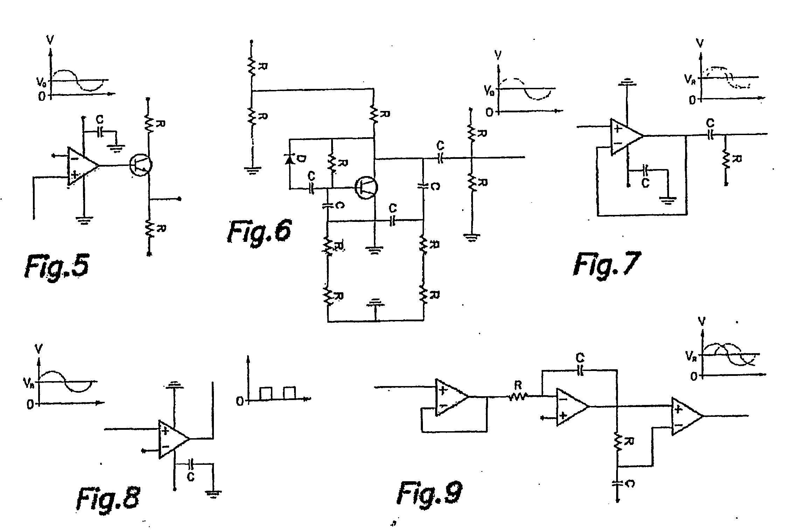

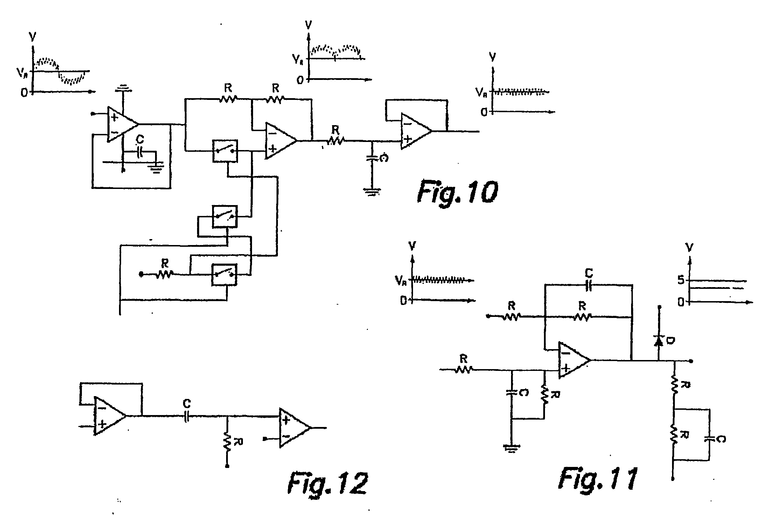

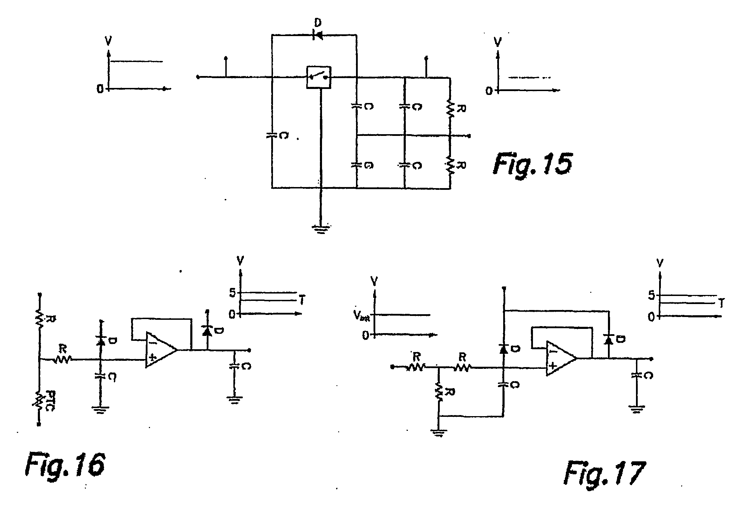

According to this invention, the system comprises:
- block 6: a conventional oscillator, detailed in figure 6, which provides an alternating sinusoidal voltage signal at a determined reference frequency, for example 90 Hz, continuously superimposed on a component as a reference.
- block 5: a circuit, detailed in figure 5, for injecting a current in the range of 100 mA to the battery posts, comprising an operational amplifier which is fed by the voltage of the oscillator and which has a transistor.
- block 15: shown in figure 15 and consisting of a standard voltage regulator providing a reference voltage, for example 4 V
- block 2: a filtering assembly prior to the alternating voltage signal generated in the battery posts (in the range of 100 µV) as a consequence of the current injection, comprising a filtering stage with several sub-stages and an amplification stage and ending in an operational amplifier in tracker assembly for isolation, the structure is shown in detail in figure 2;
- block 7: detailed in figure 7, a circuit for phase correction of the voltage generated by the oscillator 6 in order to offset the phase mismatches induced by the electronic measurement stages in each one of the synchronous filtering stages used for measuring the actual and imaginary components of the electrochemical impedance of the battery;
- block 9: detailed in figure 9, it carries out a phase shift at 90° of said voltage signal generated by the oscillator (corrected in phase by block 7) for calculating the imaginary component of the electrochemical impedance of the battery;
- blocks 3, 10, 13: shown in figures 3, 10 and 13 and basically equivalents, consisting of a synchronous filter (at a working frequency set by the oscillator), in which the signal evolution has been included at several points of the circuit and which has three interrelated, solid state analog switches, two of them receiving the control signal coming from the oscillator (through a control device such as that shown in block 8) and one of said two switches connected to the third, comprising a first operational A applied to the rectification of the reference signal at the working frequency and a second operational B applied to the filtering of the rest of the signals appearing in the measurement in order to thus obtain a continuous voltage proportional to the electrochemical impedance component of the battery;
- block 8: control circuit of the synchronous filter, shown in figure 8 and likewise present as an end component of blocks 9 and 12 with slight variations.
- block 12: circuit detailed in figure 12 prepared for the acquisition of the voltage values of the oscillator (without inclusion of the phase shift) corresponding to the injected signal and finalized in a control stage of the synchronous filter of block 13;
- blocks 4, 11 and 14: detailed in figures 4, 11 and 14, comprising stages of matching the measured signals to the electrical features of the microcontroller with the elimination of the reference, stabilization of each voltage value and matching to the voltage levels in order to optimize the dynamic range of said microcontroller.

Thus, blocks 2, 9 and 12, which provide the voltage signal generated in the battery posts, said signal phase shifted 90° and the voltage value of the oscillator, respectively, feed several corresponding synchronous detection filtering circuits (blocks 3, 10 and 13, respectively) in order to proceed from them to provide a suitable signal in corresponding blocks 4, 11 and 14 so that the microcontroller can efficiently calculate the electrochemical impedance and the SOC and SOH of the battery, for which the information continuously provided by blocks 16 and 17 shown in the figures with the same numbers is also taken into account, the first acquiring the temperature of the inside of the battery (reflected on a scale of 0 -5 V) through a probe, for example a PTC, and the second constantly providing values proportional to the battery voltage in a range of 0-5 V.

It can be seen that the stages of the described circuits have always been constructed on the basis of assemblies with operational amplifiers in different shapes and as from discrete components available on the market, it is important to state that said circuits are only informative about a possible implementation of the invention, which is delimited in its essential features in the following claims.

## Claims

1. A system for the dynamic evaluation of the state of health and charge of the battery of a vehicle, based on the determination of the electrochemical impedance of the battery as from the measurement of the sinusoidal voltage increase ΔV=Vₘₐₓ sen(2Πf t) when a sinusoidal current ΔI=Iₘₐₓ sen(2Πf t+Φ) is added to the normal charging and discharging current of the battery, where f is the frequency and Iₘₐₓ is the amplitude of the superimposed sinusoidal current, with whose magnitudes the actual and imaginary component values of the electrochemical impedance of the battery Z(f)= Vₘₐₓ /Iₘₐₓe^{jΦ} are obtained, comprising for such purpose:
- means for generating said sinusoidal alternating current applied to the battery posts;
- means for measuring the voltage drop in said battery posts, caused by the passage of said current;
- means for filtering and conditioning said voltage drop, using at least one synchronous filter controlled by the original generated current signal; and
- means for acquiring a continuous voltage value proportional to the electrochemical impedance of the battery, obtaining as from this the actual and imaginary component of the electrochemical impedance of the battery;
**characterized in that** said evaluation system is based on a unipolar architecture (mass and feeding) where the injected signal consists of an alternating component at only one frequency provided by an oscillator, continuously superimposed on a reference component, and **in that** the system is foreseen for operating both in standstill and functioning of the vehicle, integrated therein.

2. A system according to the previous claim, **characterized in that** it comprises means for continuously obtaining the measurements of the actual and imaginary components over time, using for such purpose a synchronous detection filter controlled by the original generated current signal for obtaining from each one of said components and also by comprising means for acquiring at all times and also by means of a synchronous detection filter a voltage proportional to the injected current at all times.

3. A system according to claim 2, **characterized in that** it also comprises means for offsetting the phase mismatches induced by the electronic measurement stages in each one of the two synchronous filter stages used for measuring the actual and imaginary components of the electrochemical impedance of the battery, consisting of a phase shifter circuit which is looped in the signal which feeds said synchronous filter stages, for the control thereof.

4. A system according to claim 2, **characterized in that** it also includes means for obtaining a value of the voltage existing in the battery posts at all times.

5. A system according to claim 2, **characterized in that** it includes means for also obtaining a voltage value that is proportional to the temperature inside the battery.

6. A system according to the previous claims, **characterized in that** the values of the actual and imaginary component of the impedance together with the voltage values in the battery posts, the voltage value proportional to the temperature and the voltage value proportional to the injected current feed a microcontroller containing several algorithms for calculating the state of charge and the state of health of the battery as from said values introduced into it.

7. A system according to the previous claims, **characterized in that** it comprises means for adding a necessary voltage reference into the filtering and amplification stages in order to implement said unipolar topology.

8. A system according to claim 7, **characterized in that** said voltage reference is obtained from a voltage regulator.

9. A system according to the previous claims, **characterized in that** coupled to each one of the synchronous detection filters, it includes a stage of matching the measured signals to the electrical features of the microcontroller with the elimination of the reference, stabilization of each voltage value and matching to the voltage levels in order to optimize the dynamic range of the microcontroller.

10. A system according to the previous claims, **characterized in that** each one of the synchronous detection filters comprises three interrelated, solid state analog switches, two of them receiving a control signal coming from an oscillator and one of said first two connected to the third, comprising a first operational A applied to the rectification of the reference signal at the working frequency and a second operational B applied to the filtering of the rest of the signals appearing in the measurement in order to thus obtain a continuous voltage proportional to the electrochemical impedance component of the battery.

11. A system, **characterized in that** the acquisition of the temperature inside the battery is carried out as from a PTC probe.
